# EUROPÄISCHE PATENTSCHRIFT

(11) **EP 2 272 107 B1**
(45) Veröffentlichungstag und Bekanntmachung des Hinweises auf die Patenterteilung: **12.10.2016**
(21) Anmeldenummer: 09737878.0
(22) Anmeldetag: 29.04.2009
(51) Int. Cl.: H01L 33/50

(54) **LED MIT MEHRBAND-LEUCHTSTOFFSYSTEM**
LED COMPRISING A MULTIBAND PHOSPHOR SYSTEM
DEL A SYSTEME LUMINESCENT MULTIBANDE

(30) Priorität: 30.04.2008 DE 102008021662
(43) Veröffentlichungstag der Anmeldung: 12.01.2011
(73) Patentinhaber: Tridonic Jennersdorf GmbH, 8380 Jennersdorf (AT)
(72) Erfinder: OBERLEITNER, Wolfgang, 1030 Wien (AT)
(74) Vertreter: Rupp, Christian
(86) Internationale Anmeldenummer: PCT/EP2009/003104
(87) Internationale Veröffentlichungsnummer: WO 2009/132834

(56) Entgegenhaltungen:
- EP-A- 1 560 274
- EP-A- 1 670 070
- WO-A-2007/060573

## Beschreibung

Die vorliegende Erfindung betrifft ein LED-Modul gemäß Anspruch 1. Weitere Ausführungsformen der Erfindung werden in den abhängigen Ansprüchen definiert.

### Hintergrund der Erfindung

Aus dem Stand der Technik ist bekannt, einen Leuchtstoff auf eine vorhandene LED aufzubringen, um das von der LED emittierte Lichtspektrum wenigstens teilweise in ein anderes Lichtspektrum zu konvertieren. Dabei wird die von der LED emittierte Strahlung wenigstens teilweise von dem Leuchtstoff absorbiert, welcher somit zur Photolumineszenz angeregt wird. Die resultierende Emissions- bzw. Lichtfarbe des LED-Moduls bzw. der Lichtquelle ergibt sich dann aus der Mischung des transmittierten (d.h. nicht konvertierten) Anteils des Spektrums der LED und dem Emissionsspektrum des Leuchtstoffes.

Zur Erzeugung von weißem Licht wird dabei vorzugsweise eine LED verwendet, welche blaues Licht und damit Licht einer Wellenlänge von etwa 440-480 nm emittiert. Als Leuchtstoff wird beispielsweise dotierter YAG (Yttrium-Aluminium-Granat) verwendet, welcher je nach Konzentration Teile des von der LED emittierten blauen Lichts absorbiert und mit hoher Effizienz in größtenteils gelbe Lumineszenzstrahlung umwandelt. Zudem kann als Leuchtstoff eine Mischung aus grünem und rotem Leuchtstoff verwendet werden, welche das blaue Licht der LED wenigstens teilweise in grüne und rote Lumineszenzstrahlung konvertiert. Durch die daraus resultierende additive Farbmischung der Farben blau, rot und grün kann somit weißes Licht erzeugt werden.

Zusätzlich ist es möglich, ein Dreibandphosphorsystem auf die blaue LED aufzubringen. Hierbei werden drei verschiedene Leuchtstoffe auf die LED aufgebracht, welche das emittierte Licht der LED in grüne, rote und gelbe Lumineszenzstrahlung konvertieren.

Bei den oben dargestellten Leuchtstoffsystemen ist es besonders wünschenswert, einen hohen Farbwiedergabewert (CIE Color Rendering Index (CRI)) der herzustellenden LED zu erhalten. Darunter versteht man eine photometrische Größe, mit welcher sich die Qualität der Farbwiedergabe von Lichtquellen gleicher korrelierter Farbtemperatur beschreiben lässt. Je nachdem, wie viele der insgesamt 16 Standardfarben für die Berechnung des Farbwiedergabewertes herangezogen werden, werden verschiedene Farbwiedergabewerte definiert, die gebräuchlichsten sind dabei RA8 und RA14. Spektralanteile außerhalb des sichtbaren Bereiches spielen keine Rolle bei der Ermittlung des Farbwiedergabewertes.

DE 10 2006 016 548 A1 beschreibt einen blau bis gelb emittierenden Leuchtstoff, welcher aus einem Nitrido-Orthosilikat besteht und die Herstellung von farbstabilen, effizienten LEDs mit guter Farbwiedergabe ermöglichen soll. Zudem ist der Leuchtstoff sehr strahlungsstabil, was den Einsatz in High-brightness LEDs ermöglicht.
Es ist dabei eine Vermischung des Leuchtstoffs mit insbesondere drei Leuchtstoffen vorgesehen, um warmweiße LEDs mit hohem Farbwiedergabeindex Ra von bis zu 97 bereitzustellen. Neben dem neuen grüngelben Leuchtstoff ist ein roter, insbesondere nitridischer Leuchtstoff hinzugefügt.

DE 10 2007 001 903 A1 beschreibt einen Leuchtstoffkörper enthaltend Cr(III) aktiviertes Aluminiumoxid (Rubin), dessen Herstellung sowie dessen Verwendung als LED-Konversionsleuchtstoff für weiße LEDs oder sogenannte Colour-on-demand Anwendungen vorgesehen ist.
Als rötlicher Leuchtstoff kann Nitridosilikat verwendet werden. Zu dem wird die Verwendung eines mit Ce dotierten YAG-Leuchtstoffs gezeigt.
Der Leuchtstoffkörper wird vorzugsweise dazu verwendet, stabile Farbpunkte für Colour-on-demand LED Anwendungen mit roten Lichtanteilen zu realisieren. Demzufolge wird ein zuvor festgelegter Farbwert durch entsprechende Mischung des Rubin enthaltenden Leuchtstoffkörpers mit einem weiteren Konversionsleuchtstoff erzielt, wobei die tiefrote Emission zu einer überlegenen Farbwiedergabe führt.

Ein- und Zweikomponenten-Leuchtstoffsysteme weisen gegenüber Dreikomponenten-Leuchtstoffsystemen den Nachteil auf, dass bei konstanter Farbtemperatur, bei konstanter Wellenlänge sowie konstanter Leistung der LED-Chips und bei einem absolut gleichartigen LED-Package, abgesehen von statistischen Schwankungen, nur ein Farbwiedergabewert und ein Lichtstrom erzielbar sind. Eine exakte Einstellung des Farbwiedergabewertes ist daher mit Ein- und Zweikomponenten-Leuchtstoffsystemen nicht möglich.

Die aus dem Stand der Technik bekannten Dreibandphosphorsysteme weisen den Nachteil auf, dass mit steigendem Farbwiedergabewert der LED gleichzeitig die Lichtausbeute sinkt. Um eine möglichst hohe Lichtausbeute eines LED-Moduls zu erzielen, sollte daher der Farbwiedergabewert nicht über zuvor definierten Anforderungen liegen, um keinen Nachteil hinsichtlich der Lichtausbeute zu erhalten. Eine exakte Einstellung des Farbwiedergabewertes ist daher wünschenswert.

Ein Problem insbesondere der Mehrbandphosphorsysteme ist zudem die Tatsache, dass die Lichtkonversion durch die Leuchtstoffe von der Temperatur in der Farbkonversionsschicht, in der sich die Leuchtstoffe befinden, abhängt. Zudem hat der durch die LED fließende Strom einen entscheidenden Einfluss auf die Lichtkonversion innerhalb der Farbkonversionsschicht. In den bekannten Mehrbandphosphorssystemen stellt sich tendenziell eine gewisse Leistungsabnahme der Farbkonversion bei höheren Temperaturen und/oder höheren Strömen durch die LED ein (Quenching- bzw. Sättigungseffekte). Durch diese Abnahme der Leuchtstoffeffizienz verschiebt sich der Farbort des emittierten Lichts des LED-Moduls, welcher durch x- und y-Koordinaten der CIE-Normfarbtafel ausgedrückt werden kann.

Ziel der vorliegenden Erfindung ist es daher, ein bezüglich der Temperatur und des Stromflusses durch die LED stabiles Dreibandphosphorsystem für ein LED-Modul bereitzustellen, welches bei einem zuvor definierten Farbwiedergabewert des LED-Moduls eine größtmögliche Lichtausbeute ermöglicht.

WO 2007/060573 A ofefnbart ein LED-Modul, aufweisend mindestens eine blaue oder UV-LED und eine darauf aufgebrachte Farbkonversionsschicht, welches Modul ein weisses Mischlicht aus dem Spektrum des Lichts der LED und dem konvertierten Spektrum der Farbkonversionsschicht ausstrahlt, wobei
- die Farbkonversionsschicht wenigstens drei unterschiedliche Leuchtstoffe aufweist, welche das Licht der blauen LED zumindest teilweise in rotes, grünes und gelbes bzw. gelbgrünes Licht konvertierten und
- der Leuchtstoff zur Konversion in rotes Licht eine dotierte Nitrid-Verbindung, vorzugsweise ein Nitridosilikat ist,
- der Leuchtstoff zur Konversion in grünes Licht ein mit Europium dotiertes Erdalkaliorthosilikat ist.

### Ziel und Zusammenfassung der Erfindung

Die Erfindung behandelt ein LED-Modul aufweisend mindestens eine blaue LED und eine darauf aufgebrachte Farbkonversionsschicht, welche ein Mischlicht aus dem blauen Licht der LED und dem konvertierten Spektrum der Farbkonversionsschicht ausstrahlt, wobei die Farbkonversionsschicht wenigstens drei unterschiedliche Leuchtstoffe aufweist, welche das Licht der blauen LED zumindest teilweise in rotes, grünes und gelbes bzw. gelbgrünes Licht konvertieren und wobei der Leuchtstoff zur Konversion in rotes Licht eine dotierte Nitrid-Verbindung, vorzugsweise ein Nitridosilikat ist.

Durch die erfindungsgemäße Farbkonversionsschicht erfolgt demnach zumindest teilweise eine Konversion des von der LED emittierten blauen Lichts in rotes, grünes und gelbes Licht, wodurch aufgrund der additiven Farbmischung ein weißes Licht von dem LED-Modul abgestrahlt wird.

Die Farbkonversionsschicht wird erfindungsgemäß derart auf die LED aufgebracht, dass die gesamte Licht emittierende Oberfläche der LED durch die Farbkonversionsschicht abgedeckt ist. Demnach wird vorzugsweise das gesamte Licht, welches von der LED emittiert wird, durch die Farbkonversionsschicht transmittiert.

Die Farbkonversionsschicht besteht vorzugsweise aus einem optisch transparenten Material, welches Phosphorpartikel als Leuchtstoff enthält. Erfindungsgemäß enthält die Farbkonversionsschicht mindestens drei unterschiedliche Leuchtstoffarten. Darunter mindestens einen Leuchtstoff, welcher das von der LED emittierte Licht in rotes Licht konvertiert. Dieser Leuchtstoff ist vorzugsweise eine Nitrid-Verbindung, beispielsweise ein dotiertes Nitridosilikat, wie es als solches bspw. aus der WO 2006/114077 bekannt ist.

Zusätzlich enthält die Farbkonversionsschicht einen Leuchtstoff, welcher das von der LED emittierte Licht in grünes Licht konvertiert. Dieser ist ein mit Europium dotiertes Erdalkalimetallorthosilikat. Als Erdalkalimetalle können Ba, Sr, Ca oder Mischungen dieser Elemente verwendet werden. Ein mit Europium dotiertes Bariumorthosilikat ("BOSE") ist aus der WO 2002/054502 A1 bekannt.

Des Weiteren enthält die Farbkonversionsschicht einen Leuchtstoff, welcher das von der LED emittierte Licht in gelbes Licht konvertiert. Dieser ist ein dotierter YAG. Im erfindungsgemäßen Dreibandphosphorsystem kann durch den dotierten YAG-Leuchtstoff eine Maximierung des Lichtstromes erreicht werden.

Aus dem Stand der Technik sind die oben genannten Leuchtstoffe bereits bekannt, diese weisen jedoch teilweise erhebliche Nachteile auf. So weist der YAG-Leuchtstoff abhängig von der zu erzielenden ähnlichsten Farbtemperatur einen geringen Farbwiedergabewert von circa 65 bis 75 auf. Ein BOSE Leuchtstoff hat zudem den Nachteil, dass der Farbort von der Temperatur in der Farbkonversionsschicht und der Umgebungstemperatur abhängt. Zudem hat der Stromfluss durch die LED einen Einfluss auf den Farbort. Dieser negative Einfluss ist besonders bei gelbem und orangem BOSE Leuchtstoff stark ausgeprägt.

Aus dem Stand der Technik ist zudem eine Kombination von grünem und rotem Leuchtstoff bekannt, wodurch ein hoher Farbwiedergabewert erreicht werden kann. Aufgrund der geringen Sensitivität des menschlichen Auges bezüglich der Farbe Rot führt die Verwendung der Kombination aus grünem und rotem Leuchtstoff allerdings zu einem wesentlich verringerten Lichtstrom. Zudem weist der grüne Leuchtstoff teilweise eine schlechte Anregung durch blaue LEDs auf, wodurch die Lichtausbeute zusätzlich verringert wird.

Das erfindungsgemäße Dreibandphosphorsystem ermöglicht die Konversion des von der LED emittierten blauen Lichts, wobei die oben genannten Nachteile durch das erfindungsgemäße Mischverhältnis des Dreibandphosphorsystems eliminiert werden können.

Die prozentualen Anteile der einzelnen Leuchtstoffe des erfindungsgemäßen Mehrbandphosphorsystems innerhalb der Farbkonversionsschicht sind vorzugsweise wie folgt:
- grüner Erdalkaliorthosilikat Leuchtstoff: 10-50%
- roter Nitrid Leuchtstoff: 10-30%
- gelber YAG Leuchtstoff: 20-80%

Dabei hat der grüne Leuchtstoff eine bevorzugte Hauptwellenlänge von 520 bis 530nm. Die Hauptwellenlänge des roten Leuchtstoffs beträgt bevorzugt zwischen 630 und 650 nm und die des gelben Leuchtstoffs beträgt bevorzugt zwischen 555 und 570 nm.

Durch die oben ausgeführte Wahl des Mischverhältnisses der Leuchtstoffe in der Farbkonversionsschicht kann bei einem vorgegebenen Farbwiedergabewert des LED-Moduls eine größtmögliche Lichtausbeute des Moduls erzielt werden.

**Tabelle 1 -Lichtstromwerte und Farbwiedergabewerte für unterschiedliche Zusammensetzungen des erfindungsgemäßen Dreibandphosphorsystems**

| **Lichtstrom** | **RA8** | **Verhältnis YAG / BOSE / Nitrid** |
|---|---|---|
| 30,8 | 95,2 | 30,0 / 50,5 / 19,5 |
| 32,6 | 92,1 | 41,0 / 40,0 / 19,0 |

In Tabelle 1 sind Messwerte des Lichtstroms angegeben, welche durch die ebenfalls angegebenen Mischverhältnisse des erfindungsgemäßen Dreibandphosphorsystems erzielbar sind. Zusätzlich ist der jeweilige Farbwiedergabewert (RA8) angegeben.

Grundlage der angegebenen Lichtstromwerte bildet die Messung von jeweils 20 LEDs gleicher Chipleistung (240-260mW) und Chipwellenlänge (462,5-465nm). Der Farbort hierbei liegt bei x = 0,409 ± 0,010, y = 0,394 ± 0,010 der CIE-Normfarbtafel. Die ±-Werte sind dabei keine Standardabweichungen, sondern absolute Grenzen.

Wie in der Tabelle 1 dargestellt, erhöht sich bei Erhöhung des YAG-Anteils auf Kosten des BOSE-Anteils der Lichtstrom um ca. 6%, während sich der Farbwiedergabewert (RA8) um ca. 3 Einheiten verringert.

Bei LED-Modulen, bei denen ein Farbwiedergabewert RA8 = 90 gefordert ist, durch Verwendung eines binären Leuchtstoffsystems aber 93 erreicht wird, verliert man demzufolge mehrere Prozent an Licht durch einen zu hohen Farbwiedergabewert. Dieser Verlust erhöht sich speziell bei Verwendung alternativer und weniger effizienter Grünleuchtstoffe, welche keine BOSE-Leuchtstoffe sind, auf bis zu 10%.

Im Gegensatz zu einem binären Phosphorsystem weist das erfindungsgemäße Dreibandphosphorsystem den Vorteil auf, dass der Farbwiedergabewert in weiten Bereichen frei einstellbar ist. Der Farbwiedergabewert ist insbesondere zwischen dem Farbwiedergabewert, der mit reinem YAG-Leuchtstoff erzielt wird, d.h. ohne Nitrid- und BOSE-Beimengungen, etwa 75 bei 5700K, und jenem, der mit der binären BOSE-Nitrid Mischung erzielt wird, bis zu knapp 100 bei 4000K, frei einstellbar. Durch die Einstellung des Farbwiedergabewertes kann dieser auf einen zuvor definierten Farbwiedergabewert angepasst werden. Eine Verringerung des Farbwiedergabewertes führt dabei zu einer Erhöhung des Lichtstroms. Die exakte Einstellung des Farbwiedergabewertes auf einen zuvor definierten Wert hat demzufolge den Vorteil, dass keine Lumenverluste durch einen "zu hohen" Farbwiedergabewert auftreten.

Die oben beschriebene Einstellung bzw. Anpassung des LED-Moduls an einen zuvor definierten Farbwiedergabewert ist mit Hilfe einer statistischen Versuchsplanung (DOE) möglich. Diese ermöglicht insbesondere eine Feineinstellung des Farbwiedergabewertes und eine Optimierung des Leuchtstoffkomponentenverhältnisses des erfindungsgemäßen Dreibandphosphorsystems. Demzufolge kann bei einem vorgegebenen Farbwiedergabewert eine größtmögliche Lichtausbeute des LED-Moduls erzielt werden.

Hierfür kann ein Verfahren zur Feineinstellung des Farbwiedergabewerts und zur Optimierung des Leuchtstoffkomponentenverhältnisses eines Dreibandphosphorsystems eines LED-Moduls eingesetzt werden.
Hierbei werden in einem ersten Schritt die zu optimierenden Parameter, insbesondere die Konzentrationen der drei Leuchtstoffkomponenten c(A), c(B), c(C), und die sogenannten "Response"-Größen, welche maximiert oder minimiert werden sollen, z.B. der Lichtstrom und der Farbwiedergabewert, definiert.
In einem zweiten Schritt wird die notwendige Anzahl an Versuchen mit den jeweils darin zu verwendenden Parameterwerten berechnet.
In einem dritten Schritt werden die bestimmte Anzahl an Versuchen mit den jeweils dafür bestimmten Parameterwerten durchgeführt.
Zuletzt werden in einem vierten Schritt anhand der aus den Versuchen ermittelten Werte der "Response"-Größen die optimalen Parameterwerte berechnet.

Die Schritte 2 bis 4 können dabei beliebig oft wiederholt werden.

Außerdem kann eine abschließende Feineinstellung der Phosphorzusammensetzung vorgenommen werden.

Bei dem Verfahren wird vorzugsweise eine statistische Versuchsplanung, d.h. ein Design of Experiments, angewandt.

Im ersten Schritt kann außerdem ein Versuchsplan, z.B. ein faktorieller Versuchsplan, festgelegt werden.

Vorzugsweise wird zur Durchführung des Verfahrens, insbesondere für den zweiten und den vierten Schritt, ein Computerprogramm verwendet.

Falls nur eine oder zwei Farbtemperaturen erforderlich sind, führt hingegen ein alternatives Verfahren schneller zum Ziel.

Dieses Verfahren dient wieder zur Feineinstellung des Farbwiedergabewerts und zur Optimierung des Leuchtstoffkomponentenverhältnisses eines Dreibandphosphorsystems eines LED-Moduls,
welches mindestens eine blaue oder UV-LED und eine darauf aufgebrachte Farbkonversionsschicht mit dem Dreibandphosphorsystem aufweist.
Dabei wird in einem ersten Schritt nur ein Zweibandphosphorsystem verwendet wird, z.B. gelb und rot, welches einen zu niedrigen Farbwiedergabewert aufweist. Anschließend werden einem zweiten Schritt solange Teile einer Leuchtstoffkomponente des Zweibandphosphorsystems, beispielsweise das gelbe Phosphor, durch eine neue Leuchtstoffkomponente, beispielsweise grünes Phosphor, schrittweise ersetzt, bis der spezifizierte Farbwiedergabewert erreicht ist.

Im zweiten Schritt wird vorzugsweise darüber hinaus die Leuchtstoffkomponente des Zweibandphosphorsystems, die nicht ersetzt wird, zwecks Konstanthaltung des Farbortes erhöht. Dabei könnte es sich beispielsweise um das rote Phosphor handeln.

Das Verfahren wird bevorzugt mit einer manuellen Iteration, ohne Anwendung einer statistischen Versuchsplanung, durchgeführt.

Ein weiterer erfindungsgemäßer Vorteil ist, dass das erfindungsgemäße Dreibandphosphorsystem eine sehr gute Stabilität bei hohen Temperaturen in der Farbkonversionsschicht und/oder bei hohen Stromstärken durch die LED aufweist.

Die erfindungsgemäße Leuchtstoffmischung weist eine besonders hohe Farbstabilität vorzugsweise bei Stromstärken bis 1000mA und hohen Farbwiedergabewerten auf. Dies ist insbesondere bei warmweißen LEDs mit einem hohen Farbwiedergabewert vorteilhaft, welche bei Strömen über 500mA aufgrund der hohen Leuchtstoffkonzentration oft eine geringe Stabilität des Phosphorsystems aufweisen, wodurch Quenchingeffekte entstehen. Grund hierfür ist, dass der Anteil an konvertiertem Licht im emittierten LED-Spektrum umso höher ist, je niedriger die Farbtemperatur und je höher der Farbwiedergabewert ist. Je höher der Anteil an konvertiertem Licht ist, umso höher ist die Wärmeentwicklung in der Farbkonversionsschicht der LED aufgrund der Energiedifferenz zwischen anregender und emittierender Strahlung und desto wahrscheinlicher sind Quenchingeffekte (beispielsweise strahlungslose Übergänge) und somit eine Leistungsabnahme des Leuchtstoffs.

Die Stabilität des erfindungsgemäßen Dreibandphosphorsystems ermöglicht daher unter anderem den Betrieb von warmweißen LEDs mit hohen Farbwiedergabewerten bei hohen Strömen (typischerweise CCT < 4500K und RA8 ≥ 80).

Es ist darauf hinzuweisen, dass hierbei die Gesamtheit des Phosphorsystems - und nicht die Einzelkomponenten - betrachtet werden muss, da unterschiedliche Eigenschaften einzelner Komponenten des Phosphorsystems eine Verstärkung bzw. eine Abschwächung eines Effekts bewirken können.

Die erfindungsgemäße Leuchtstoffmischung weist zudem eine besonders hohe Farbstabilität vorzugsweise bei Temperaturen zwischen 25 und 85°C auf. Die angegebenen Temperaturen beziehen sich auf die jeweilige Umgebungstemperatur. Um diese Stabilität in dem angegebenen Temperaturbereich zu gewährleisten, ist ein Mindestmaß an Wärmeabfuhr von der Sperrschicht des LED-Chips notwendig. Der Wärmewiderstand der Sperrschicht des LED-Chips zur Umgebung sollte daher nicht größer als 50K/W sein.

Ein weiterer Vorteil der vorliegenden Erfindung besteht darin, dass die erfindungsgemäße Leuchtstoffmischung eine hohe Stabilität auch bei hohen Feuchtigkeiten aufweist.

Das erfindungsgemäße LED-Modul weist vorzugsweise einen Farbwiedergabewert zwischen 80 und 95 auf.

Die mechanische Ausführung des erfindungsgemäßen LED-Moduls ist auf vielfältige Art und Weise möglich. Gemäß einer ersten bevorzugten Ausführungsform ist es vorgesehen, dass ein oder mehrere LED-Chips auf einem Substrat innerhalb eines Reflektors angeordnet sind und der Leuchtstoff in einer vorgefertigten Folie, welche über den LED-Chips angeordnet ist, dispergiert ist.

Es ist aber auch möglich, dass ein oder mehrere LED-Chips auf einer Leiterplatte innerhalb eines Reflektors angeordnet sind und der Leuchtstoff auf dem Reflektor aufgebracht ist.

Vorzugsweise sind die LED-Chips mit einer transparenten Vergussmasse, die eine kuppelartige Form besitzt, vergossen. Diese Vergussmasse bildet einerseits einen mechanischen Schutz, andererseits werden durch die Vergussmasse auch die optischen Eigenschaften des LED-Moduls verbessert. So wird beispielsweise der Lichtaustritt aus dem LED-Chip verbessert. Zudem kann der LED-Chip in einer Ausnehmung einer Leiterplatte angeordnet sein, welche mit Hilfe von Vergussmasse aufgefüllt wird. Die Vergussmasse weist vorzugsweise transparentes Silikon auf.

In einer weiteren bevorzugten Ausführungsform ist der Leuchtstoff in eine Vergussmasse dispergiert, die eine Anordnung von LED-Chips auf einer Leiterplatte möglichst ohne Gaseinschlüsse überdeckt. Dabei schließt die Vergussmasse vorzugsweise den LED-Chip komplett ein, so dass dessen gesamte Oberfläche von der Vergussmasse bedeckt ist. Zudem ist es möglich, dass der LED-Chip von einer transparenten Vergussmasse eingeschlossen ist, welche keine Leuchtstoffe enthält und eine weitere Vergussmasse mit enthaltenen Leuchtstoffen auf der transparenten Vergussmasse angeordnet ist. Durch ähnliche Brechungsindizes der Vergussmassen kann die Reflexion an den Grenzflächen auf ein Minimum reduziert werden.

Ein erfindungsgemässes LED-Modul ist derart ausgestaltet, dass bei einer Testzeit von t=0 bis t=1000 Stunden die Farbkoordinaten der CIE-Normfarbtafel des von dem LED-Modul emittierten Lichts bei 85°C und 85% relativer Luftfeuchte eine maximale Abweichung von ±0,05% aufweisen.

Bei einer Testzeit von t=0 bis t=1000 Stunden weist der relative Lichtstrom des von dem LED-Modul emittierten Lichts bei 85°C und 85% relativer Luftfeuchte eine maximale Abweichung von 5% auf.

Dabei kann jeweils ein Strom von I=0 oder I=700mA am LED-Modul anliegen.

Eine Änderung des Stromflusses durch das LED-Modul im Bereich von 100 bis 700 mA verursacht dabei eine Änderung des Farborts des von dem LED-Modul emittierten Lichts begründet, welcher durch Farbkoordinaten der CIE-Normfarbtafel beschrieben ist, von weniger als 30% der Längsachse einer MacAdam6 Ellipse.

Eine Änderung der Umgebungstemperatur des LED-Moduls im Bereich von 25 bis 85°C verursacht dabei eine Änderung des Farbortes des von dem LED-Modul emittierten Lichts begründet, welcher durch Farbkoordinaten der CIE-Normfarbtafel beschrieben ist, von maximal einem Fünftel der Längsachse einer MacAdam6 Ellipse.

### Kurzbeschreibung der Zeichnungen

Ein bevorzugtes Ausführungsbeispiel des erfindungsgemäßen LED-Moduls ist in den Zeichnungen darstellt und wird in der nachfolgenden Beschreibung näher erläutert.
- Abb.: 1 zeigt eine schematische Darstellung des erfindungsgemäßen LED-Moduls nach einer bevorzugten Ausführungsform.
- Abb.: 2 zeigt eine schematische Darstellung des erfindungsgemäßen LED-Moduls nach einer weiteren bevorzugten Ausführungsform.
- Abb.: 3a und 3b zeigen den Lichtstrom eines emittierten Lichts als Funktion der Testzeit eines erfindungsgemäßen LED-Moduls in unbestromtem und bestromtem Zustand bei 85°C und 85% rel. Luftfeuchte.
- Abb.: 4a und 4b zeigen die relativen Farbkoordinaten eines emittierten Lichts als Funktion der Testzeit eines erfindungsgemäßen LED-Moduls in unbestromtem und bestromtem Zustand bei 85°C und 85% rel. Luftfeuchte.
- Abb.: 5 zeigt die Änderung des Lichtstroms als Funktion des Betriebstroms eines erfindungsgemäßen LED-Moduls
- Abb.: 6a zeigt die Änderung der relativen Farbkoordinaten des emittierten Lichts als Funktion des Betriebsstroms im Bereich von 100 - 700mA.
- Abb.: 6b zeigt die Änderung der relativen Farbkoordinaten des emittierten Lichts als Funktion der Umgebungstemperatur im Bereich von 25 - 85°C.

Abb. 7 zeigt ein erstes Verfahrensbeispiel zur Feineinstellung des Farbwiedergabewerts und zur Optimierung des Leuchtstoffkomponentenverhältnisses eines Dreibandphosphorsystems eines LED-Moduls.
Abb. 8 zeigt ein zweites Verfahrensbeispiel zur Feineinstellung des Farbwiedergabewerts und zur Optimierung des Leuchtstoffkomponentenverhältnisses eines Dreibandphosphorsystems eines LED-Moduls.

### Genaue Beschreibung der Ausführungen

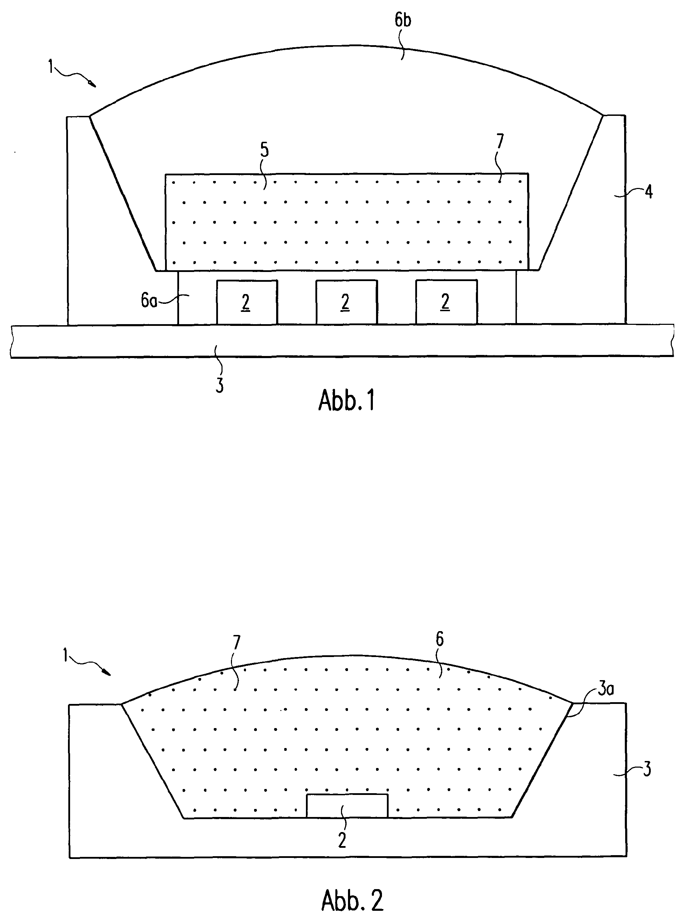

Abbildung 1 zeigt eine erste bevorzugte Ausführungsform des erfindungsgemäßen LED-Moduls 1. Dabei sind ein oder mehrere LED-Chips 2 auf einem Substrat 3 aufgebracht. Die LED-Chips können in Face-Up or Face-Down Position auf dem Substrat 3 befestigt sein. Ebenfalls auf dem Substrat 3 und um die LED-Chips 2 ist ein Reflektor 4 angebracht, welcher vorzugsweise eine reflektierende Oberfläche aufweist. Innerhalb des Reflektors 4 ist eine Farbkonversionsfolie 5 angeordnet. Diese dient einerseits zum Schutz der LED-Chips 2, andererseits enthält diese Folie 5 die erfindungsgemäße Leuchtstoffmischung 7. Die Folie 5 ist vorzugsweise vorgefertigt. Zwischen der Folie 5 und den LED-Chips 2 kann optional eine transparente Vergussmasse 6a angeordnet sein, welche vorzugsweise Silikon aufweist. Die Vergussmasse 6a wird vorzugsweise mit Hilfe eines Dispensvorgangs auf die LED-Chips aufgebracht. Oberhalb der Folie 5 ist vorzugsweise ebenfalls eine transparente Vergussmasse 6b angeordnet, welche vorzugsweise Silikon aufweist.

Das blaue Licht, welches von dem LED-Chip 2 emittiert wird, wird beim Durchgang durch die Folie 5 anteilig durch die Leuchtstoffmischung 7 in die Farben grün, gelb und rot konvertiert. Durch die additive Farbmischung ergibt sich demnach ein weißer Farbeindruck des von der Folie 5 emittierten Lichts. Es ist auch möglich, die Leuchtstoffmischung 7 auf den Reflektor 4 aufzutragen, wobei keine Folie 5 erforderlich wäre.

Abbildung 2 zeigt eine weitere bevorzugte Ausführungsform der vorliegenden Erfindung. Hierbei weist das Substrat 3 eine Kavität 3a auf, in welcher sich mindestens ein LED-Chip 2 befindet. Die Oberfläche der Kavität 3a ist vorzugsweise mit einem reflektierenden Material beschichtet. Die Kavität 3a ist zumindest teilweise mit optisch transparenter Vergussmasse 6 gefüllt, welche eine Schicht oberhalb des LED-Chips 2 bildet. Hierfür kann beispielsweise aushärtbares Kunstharz verwendet werden. Vorzugsweise enthält die Vergussmasse 6 die erfindungsgemäße Leuchtstoffmischung 7. Zwischen der Schicht 6 und dem LED-Chip 2 befindet sich vorzugsweise kein Gaseinschluss. Die Schicht 6 wird bevorzugt mit Hilfe eines Dispensvorgangs in die Kavität 3a gefüllt. Optional kann eine weitere Schicht (nicht dargestellt) zwischen der Schicht 6 und dem LED-Chip 2 angeordnet sein, welche vorzugsweise eine transparente Vergussmasse aufweist. Die Vergussmasse wird vorzugsweise mit Hilfe eines Dispensvorgangs in die Kavität 3a gefüllt.

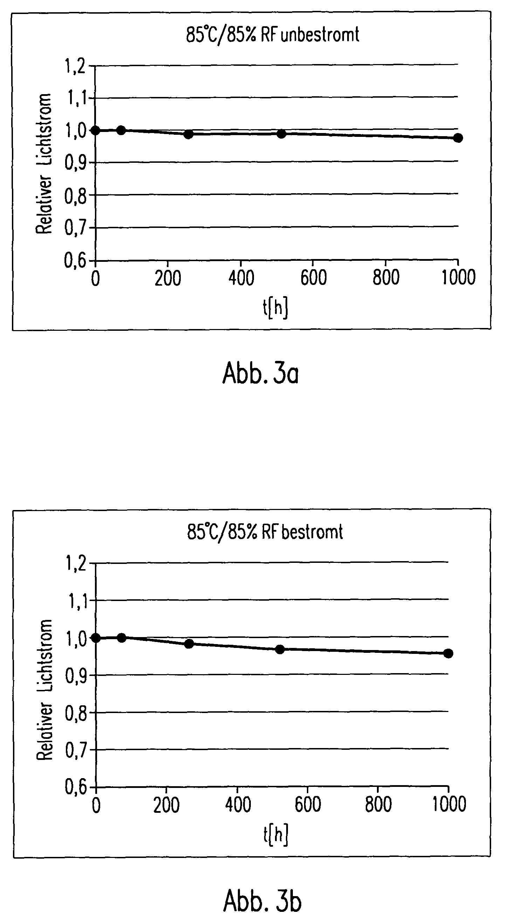

Abbildung 3a und 3b zeigen den Lichtstrom eines emittierten Lichts als Funktion der Testzeit eines erfindungsgemäßen LED-Moduls in unbestromtem und bestromtem Zustand bei 85°C und 85% rel. Luftfeuchte. Die maximale Testzeit liegt bei 1000 Stunden. Im unbestromten Zustand liegt kein Strom an dem LED-Modul an. Im bestromten Zustand liegt der maximale für das Produkt zugelassene Betriebsstrom am LED-Modul an. Dieser beträgt für Produkte im mittleren und hohen Leistungsbereich typischerweise zwischen 200 und 1000mA.

Wie in den beiden Graphen gezeigt, weist das erfindungsgemäße Dreibandphosphorsystem eine hohe Stabilität des Lichtstromes auf, selbst bei einer hohen relativen Luftfeuchtigkeit von 85%. Die gezeigte Stabilität lässt sich sowohl für den unbestromten als auch den bestromten Zustand nachweisen. Die Abweichung des Lichtstromes bei einer maximalen Testdauer von 1000 Stunden beträgt dabei maximal 5 %.

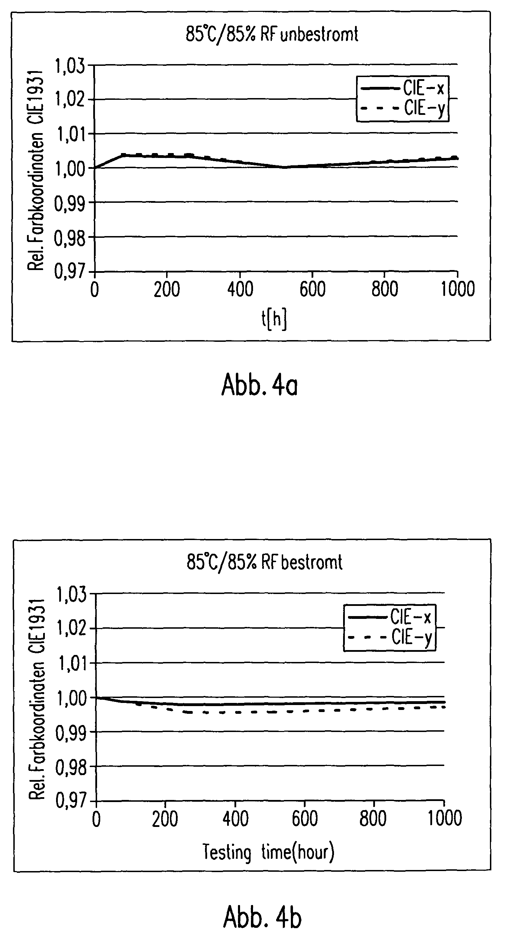

Die Abbildungen 4a und 4b zeigen die relativen Farbkoordinaten eines emittierten Lichts als Funktion der Testzeit eines erfindungsgemäßen LED-Moduls in unbestromtem und bestromtem Zustand bei 85°C und 85% rel. Luftfeuchte. Die maximale Testzeit liegt auch hier bei 1000 Stunden. Der unbestromte und der bestromte Zustand entspricht den in Abbildungen 3a und 3b beschriebenen Zuständen. Der Farbort wird mit den x- und y-Koordinaten (CIE-x, CIE-y) in der CIE-Normfarbtafel angegeben.

Den Graphen in den Abbildungen 4a und 4b ist deutlich zu entnehmen, dass das erfindungsgemäße Dreibandphosphorsystem auch in Bezug auf die Änderung des Farbortes in der Testzeit eine hohe Stabilität aufweist. Die Änderung der entsprechenden x- und y-Koordinaten weisen eine maximale Änderung von ±0,05% auf.

In den Graphen der Abbildungen 3a, 3b und 4a, 4b ist zu berücksichtigen, dass sich die gezeigten Ergebnisse nicht nur auf das erfindungsgemäße Dreibandphosphorsystem beziehen, sondern auf das gesamte LED-Modul (Gesamtpackage). Die Stabilität des Dreibandphosphorsystems kann demzufolge als besser oder zumindest als gleich gut, wie in den Abbildungen dargestellt ist, angenommen werden.

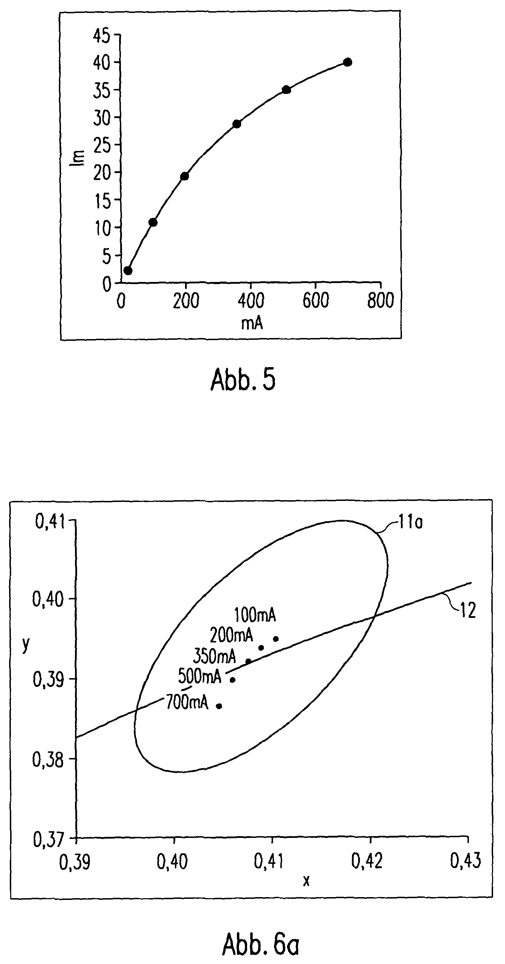

Abbildung 5 zeigt die Änderung des Lichtstromes als Funktion des Betriebsstromes eines erfindungsgemäßen LED-Moduls. Wie in dem Graph gezeigt, steigt der Lichtstrom mit zunehmendem Betriebsstrom bis 700mA stark an.

Im Gegensatz zu den bekannten Leuchtstoffsystemen, zum Beispiel einer Mischung aus BOSE-grün und BOSE-orange weist der Verlauf des Graphen demzufolge keinen Maximalwert auf, bis zu dem der Lichtstrom steigt, um danach mit weiter zunehmender Stromstärke aufgrund von Quenching- und/oder Temperatureffekten wieder abzufallen. Das erfindungsgemäße Leuchtstoffsystem weist daher eine hohe Stabilität selbst bei hohen Betriebsströmen auf, ohne dass ein Abfall des Lichtstroms eintritt.

Es ist darauf hinzuweisen, dass der maximale Strom, bei dem die Leuchtstoffmischung noch stabil ist, unter anderem stark von der Geometrie und dem Thermomanagement des LED-Moduls abhängt. Ein stabiler Betrieb der erfindungsgemäßen Leuchtstoffmischung bei 1000mA ist bei einer großen Kavität und somit einer geringen Leuchtstoffkonzentration bei 3000K und RA8=90 möglich.

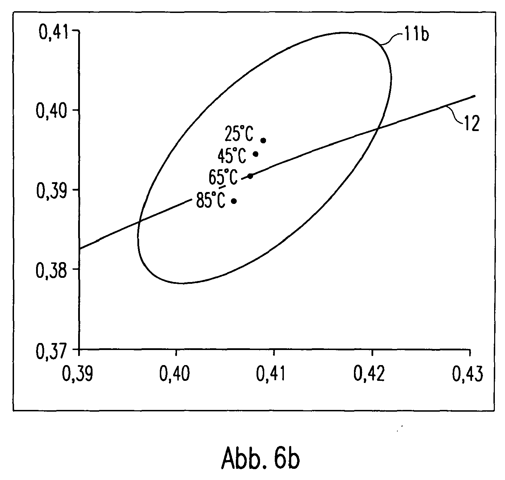

Die Abbildungen 6a und 6b zeigen die Stabilität des Phosphorsystems bei Änderungen des Betriebsstroms (100-700mA) bzw. der Umgebungstemperatur (25-85°C). Durch die x- und y-Koordinaten wird der Farbort auf einer CIE-Normfarbtafel angegeben. Die Kennlinie 12 zeigt den Plankschen Kurvenzug. Die dargestellten Toleranzfenster 11a und 11b sind MacAdam6 Ellipsen.

Der Unterschied zwischen den Farborten bei 25°C und 85°C entspricht nur etwa einem Fünftel der Längsachse der MacAdam Ellipse. Der Unterschied zwischen den Farborten bei 100mA und 700mA entspricht unter 30% der Längsachse der Ellipse.

Die aus dem Stand der Technik bekannte Schwäche, dass bei niedrigen Farbtemperaturen (warmes Weiß) und hohen Farbwiedergabewerten oft Stabilitätsprobleme der Phosphorsysteme bei hohen Stromstärken auftreten, ist den Abbildungen 6a und 6b nicht zu entnehmen. Das erfindungsgemäße Phosphorsystem zeichnet sich hingegen durch eine ausgezeichnete Stabilität hinsichtlich der Farbortverschiebung als Funktion der Umgebungstemperatur und der Stromstärke aus.

Zur Feineinstellung des Farbwiedergabewerts und zur Optimierung des Leuchtstoffkomponentenverhältnisses eines Dreibandphosphorsystems eines LED-Moduls können zwei verschiedene Verfahren eingesetzt werden.

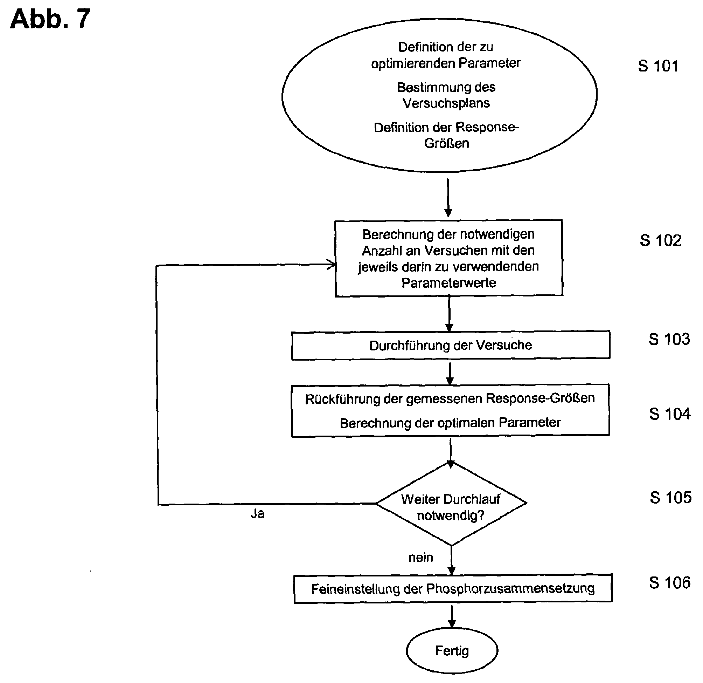

Wenn Phosphorzusammensetzungen mit definierten Farbwiedergabewerten bei mehreren Farbtemperaturen eingestellt werden sollen, kann ein sogenanntes Design of Experiments, im folgenden DOE abgekürzt, durchgeführt werden. Diese wird im ersten Verfahren angewandt, welches in Abb.7 dargestellt ist.

Hierfür wird ein entsprechendes Computerprogramme eingesetzt, mit welchen man ein DOE ausführen kann. Die Parameter, die optimieren werden sollen, also z.B. die Konzentrationen der drei Phosphore c(A), c(B), c(C), werden in Schritt S101 zuerst definiert. Des Weiteren wird der Versuchsplan, den angewandt werden soll, z.B. ein faktorieller Versuchsplan, bestimmt. Außerdem werden sogenannte "Response"-Größen, welche maximiert oder minimiert werden sollen, z.B. Lichtstrom und Farbwiedergabewert, festgelegt.

Natürlich ist es nicht möglich, Lichtstrom und Farbwiedergabewert unabhängig voneinander zu maximieren, zumal die Farbtemperatur und die dominante Wellenlänge des Chips als weitere Größen ebenfalls eine Rolle spielen.

Das Computerprogramm berechnet daraufhin in S102 eine gewisse Anzahl an auszuführenden Versuchen und die Größen der einzelnen Parameter in den Versuchen.

Nach der Versuchsdurchführung in S103 gibt der Operator in S104 die Werte der erhaltenen Response-Größen ein. Das Computerprogramm berechnet daraufhin in S105 Werte von c(A), c(B) und c(C), die für diesen ersten Durchlauf optimal sind.

Im Normalfall ist ein weiterer Durchgang in S105 sowie eine abschließende Feineinstellung der Phosphorzusammensetzung in S106 notwendig, um optimale Resultate zu erzielen.

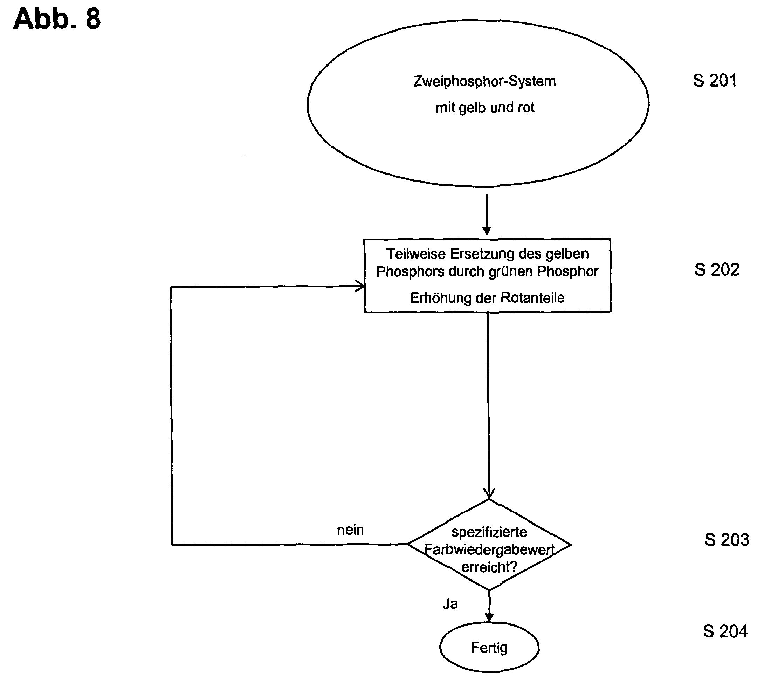

Falls nur eine oder zwei Farbtemperaturen erforderlich sind, führt hingegen ein alternatives Verfahren schneller zum Ziel, welches in Abb.8 dargestellt ist. Bei diesem wird die Einstellung ohne DOE durch manuelle Iteration vorgenommen.
Hier wird zuerst in Schritt S201 von einem Zweiphosphor-System ausgegangen, z.B. gelb und rot. Dieses weist einen zu niedrigen Farbwiedergabewert auf.
Anschließend werden in S202, durch Iteration mittels der Schleife in S203, schrittweise Teile des gelben Phosphors durch grünen Phosphor ersetzt. Gleichzeitig werden die Rotanteile zwecks Konstanthaltung des Farbortes erhöht.

Das Verfahren ist dann beendet, wenn der spezifizierte Farbwiedergabewert erreicht ist.

Auch in diesem Fall muss in Betracht gezogen werden, dass bei Änderung der Chipwellenlänge auch die Phosphozusammensetzung angepasst werden muss.

## Patentansprüche

1. LED-Modul,
aufweisend mindestens eine blaue LED und eine darauf aufgebrachte Farbkonversionsschicht, welches Modul ein weisses Mischlicht aus dem Spektrum des Lichts der LED und dem konvertierten Spektrum der Farbkonversionsschicht ausstrahlt,
wobei
- die Farbkonversionsschicht wenigstens drei unterschiedliche Leuchtstoffe aufweist, welche das Licht der blauen LED zumindest teilweise in rotes, grünes und gelbes bzw. gelbgrünes Licht konvertieren und
- der Leuchtstoff zur Konversion in rotes Licht eine dotierte Nitrid-Verbindung, vorzugsweise ein Nitridosilikat ist
- der Leuchtstoff zur Konversion in grünes Licht ein mit Europium dotiertes Erdalkaliorthosilikat ist,
- der prozentuale Anteil von Erdalkaliorthosilikat in der Farbkonversionsschicht bei 10 bis 50 Prozent liegt und
- der Leuchtstoff zur Konversion in gelbes bzw. gelbgrünes Licht ein dotierter YAG-Leuchtstoff ist, wobei der prozentuale Anteil von Leuchtstoff auf Nitrid-Basis in der Farbkonversionsschicht bei 10 bis 30 Prozent liegt, und wobei der prozentuale Anteil von Leuchtstoff auf YAG-Basis in der Farbkonversionsschicht bei 20 bis 80 Prozent liegt.

2. LED-Modul nach einem der vorhergehenden Ansprüche, wobei die Leuchtstoffe zur Konversion in rotes, grünes und gelbes bzw. gelbgrünes Licht in einem vordefinierten Verhältnis gemischt sind, um einen bestimmten Farbwiedergabewert des LED-Moduls zu erzielen.

3. LED-Modul nach Anspruch 2,
wobei das Verhältnis der Leuchtstoffe derart gewählt ist, um eine größtmögliche Lichtausbeute des LED-Moduls bei einem zuvor definierten Farbwiedergabewert zu ermöglichen.

4. LED-Modul nach einem der vorhergehenden Ansprüche,
wobei das LED-Modul einen Farbwiedergabewert zwischen 75 und 95 aufweist.

5. LED-Modul nach Anspruch 4,
wobei der Farbwiedergabewert des LED-Moduls im Bereich von 75 bei 5700K und etwa 100 bei 4000K frei einstellbar ist.

6. LED-Modul nach Anspruch 4 oder 5,
wobei die Einstellung des Farbwiedergabewerts durch eine Anpassung des Verhältnisses der Leuchtstoffe in der Farbkonversionsschicht ermöglicht ist.

7. LED-Modul nach einem der vorhergehenden Ansprüche, wobei der grüne Leuchtstoff eine Hauptwellenlänge von 520nm bis 530 nm hat.

8. LED-Modul nach einem der vorhergehenden Ansprüche, wobei der rote Leuchtstoff eine Hauptwellenlänge von 630nm bis 650 nm hat.

9. LED-Modul nach einem der vorhergehenden Ansprüche, wobei der gelbe bzw. gelbgrüne Leuchtstoff eine Hauptwellenlänge von 555nm bis 570 nm hat.

10. LED-Module nach einem der vorhergehenden Ansprüche, wobei der mit Europium dotierte Erdalkaliorthosilikat-Leuchtstoff BOSE ist.

## Claims

1. LED module comprising at least one blue LED and a color conversion layer applied thereon, wherein the module emits a white mixed light from the spectrum of light of the LED and the converted spectrum of color conversion layer, wherein
- the color conversion layer comprises at least three different phosphors, which convert the light from the blue LED at least partially into red, green and yellow or yellow-green light and
- the phosphor for conversion into red light is a doped nitride compound, preferably a nitridosilicate
- the phosphor for conversion into green light is an earth alkali orthosilicate doped with europium,
- the percentage of earth alkali orthosilicate in the color conversion layer is 10 to 50 percent, and the phosphor for conversion into yellow or yellow-green light is a doped YAG phosphor,
wherein the percentage of nitride-based phosphor in the color conversion layer is 10 to 30 percent, and wherein the percentage of YAG-based phosphor in the color conversion layer is 20 to 80 percent.

2. LED module according to one of the preceding claims,
wherein the phosphors for conversion into red, green and yellow or yellow-green light are mixed in a predefined ratio to achieve a specific color rendering value of the LED module.

3. LED module according to claim 2,
wherein the ratio of the phosphors is chosen to allow a maximum light yield of the LED module at a previously defined color rendering value.

4. LED module according to one of the preceding claims,
wherein the LED module has a color rendering value between 75 and 95.

5. LED module according to claim 4,
wherein the color rendering value of the LED module is freely adjustable in the range of 75 at 5700K and about 100 at 4000K.

6. LED module according to claim 4 or 5,
wherein the adjustment of the color rendering value is made possible by adjusting the ratio of the phosphors in the color conversion layer.

7. LED module according to one of the preceding claims,
wherein the green phosphor has a main wavelength of 520 nm to 530 nm.

8. LED module according to one of the preceding claims,
wherein the red phosphor has a main wavelength of 630 nm to 650 nm.

9. LED module according to one of the preceding claims,
wherein the yellow or yellow-green phosphor has a main wavelength of 555 nm to 570 nm.

10. LED module according to one of the preceding claims
wherein the earth alkali orthosilicate doped with europium is BOSE phosphor.

## Revendications

1. Module à LED,
comprenant au moins une LED bleue et une couche de conversion de couleurs appliquée dessus, ce module émettant une lumière mélangée blanche à partir du spectre de lumière de la LED et du spectre converti de la couche de conversion de couleurs,
- la couche de conversion de couleurs comprenant au moins trois substances luminescentes qui convertissent la lumière de la LED bleue au moins partiellement en une lumière rouge, verte et jaune ou jaune-verte et
- la substance luminescente pour la conversion en lumière rouge est un nitrure dopé, de préférence un silicate de nitrure
- la substance luminescente pour la conversion en lumière verte est un orthosilicate d'alcalino-terreux dopé avec de l'europium,
- le pourcentage d'orthoslicate d'alcalino-terreux dans la couche de conversion de couleurs est de 10 à 50 % et
- la substance luminescente pour la conversion en lumière jaune ou jeune-verte est une substance luminescente YAG dopée, le pourcentage de substance luminescente à base de nitrure dans la couche de conversion de couleurs est de 10 à 30 % et le pourcentage de substance luminescente à base de YAG dans la couche de conversion de couleurs est de 20 à 80 %.

2. Module à LED selon l'une des revendications précédentes, les substances luminescentes pour la conversion en lumière rouge, verte et jaune ou jaune-verte sont mélangées avec un rapport prédéfini afin d'obtenir une valeur de reproduction des couleurs déterminée du module à LED.

3. Module à LED selon la revendication 2,
le rapport entre les substances luminescentes est sélectionné de façon à permettre le rendement lumineux le plus important possible du module à LED pour une valeur de reproduction de couleurs définie précédemment.

4. Module à LED selon l'une des revendications précédentes, le module à LED présentant une valeur de reproduction des couleurs entre 75 et 95.

5. Module à LED selon la revendication 4,
la valeur de reproduction des couleurs du module à LED est réglable librement dans un intervalle de 75 pour 5700 K et d'environ 100 pour 4000 K.

6. Module à LED selon la revendication 4 ou 5,
le réglage de la valeur de reproduction de couleurs est permis par une adaptation du rapport ou des substances luminescentes dans la couche de conversion de couleurs.

7. Module à LED selon l'une des revendications précédentes,
la substance luminescente verte présentant une longueur d'onde principale de 520 nm à 530 nm.

8. Module à LED selon l'une des revendications précédentes,
la substance luminescente rouge présentant une longueur d'onde principale de 630 nm à 650 nm.

9. Module à LED selon l'une des revendications précédentes,
la substance luminescente jaune ou jeune-verte présentant une longueur d'onde principale de 555 nm à 570 nm.

10. Module à LED selon l'une des revendications précédentes,
la substance luminescente à base d'orthosilicate d'alcalino-terreux dopé avec de l'europium est du BOSE.
